# EUROPÄISCHE PATENTSCHRIFT

(11) **EP 1 860 447 B1**
(45) Veröffentlichungstag und Bekanntmachung des Hinweises auf die Patenterteilung: **19.10.2011**
(21) Anmeldenummer: 07009370.3
(22) Anmeldetag: 10.05.2007
(51) Int. Cl.: G01R 31/28

(54) **Prüfschaltungsanordnung und Prüfverfahren zum Prüfen einer Schaltungsstrecke einer Schaltung**
Circuit test arrangement and test method for testing a path in a circuit
Dispositif d'essais d'un circuit et procédé d'essais destinés à vérifier un chemin dans un circuit

(30) Priorität: 26.05.2006 DE 102006025031
(43) Veröffentlichungstag der Anmeldung: 28.11.2007
(73) Patentinhaber: Micronas GmbH, 79108 Freiburg (DE)
(72) Erfinder: Czech, Martin, 79427 Eschbach (DE)
(74) Vertreter: Koch Müller Patentanwaltsgesellschaft mbH

(56) Entgegenhaltungen:
- US-A1- 2001 013 790
- US-A1- 2001 015 653
- US-B1- 6 448 798

## Beschreibung

Die Erfindung bezieht sich auf eine Prüfschaltungsanordnung zum Prüfen einer Schaltungsstrecke einer Schaltung gemäß den oberbegrifflichen Merkmalen des Patentanspruchs 1 bzw. auf ein Prüfverfahren zum Prüfen einer Schaltungsstrecke gemäß den oberbegrifflichen Merkmalen des Patentanspruchs 14.

Derartige Prüfschaltungsanordnungen dienen zum Testen von unzuverlässigen Verbindungen von insbesondere integrierten Schaltungen. Integrierte Schaltungen (IC) benötigen immer mehr Strom. Deshalb werden immer mehr parallele Strompfade von außen an die integrierte Schaltung angelegt, um Widerstand und Induktivität niedrig zu halten und um den Strom gleichmäßig auf der IC verteilen zu können. Solche Strompfade sind zum Teil in einem monolithischen Fertigungsprozess mit gewohnt hoher Zuverlässigkeit und Qualität hergestellt, notwendigerweise zum Teil aber auch durch das Anfügen, beispielsweise Schweißen, Löten oder Pressen von makroskopischen Zusatzbauteilen wie Bonddrähten, Balls, Bumps und Substraten hergestellt, also Verbindungen, welche nicht monolithisch hergestellt werden. Letztere stellen ein nicht geringes Zuverlässigkeits- und Qualitätsproblem dar. Außerdem ist es messtechnisch kaum möglich, das Fehlen einer solchen Verbindung aus der Menge an parallelen Verbindung zu ermitteln.

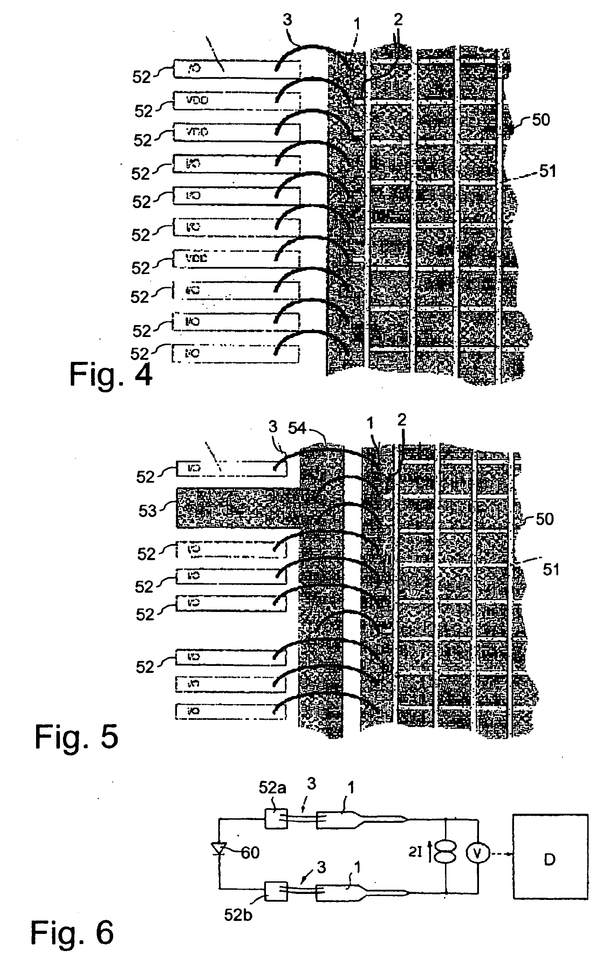

Fig. 4 zeigt einen Ausschnitt eines Kontaktierungsbereichs einer beispielhaften integrierten Schaltungsanordnung gemäß einer heute noch üblichen Ausführungsform des Standes der Technik. Dargestellt ist ein Ausschnitt eines Chips bzw. des Körpers einer integrierten Schaltung 50, auf deren Oberfläche ein Versorgungsnetz 51 aus einer Vielzahl sich kreuzender Leitungen ausgebildet ist. Im Randbereich der integrierten Schaltung 50 ist eine Vielzahl sogenannter Bond-Pads 1 angeschlossen, welche zur Kontaktierung integrierter Schaltungskomponenten und Leiterbahnen bzw. des Versorgungsnetzes 51 dienen. Dabei ist das Versorgungsnetz 51 über Verbindungsstrecken 2 in Form von Leiterbahnen mit mehreren der Pads 1 verbunden. Von den Pads 1 führen Bonddrähte als Schaltungsstrecken 3 zu Anschlussstiften 52, welche eine Kontaktierung eines Gehäuses der integrierten Schaltung 50 mit beispielsweise einem entsprechenden Sockel einer Platine ermöglichen.

Bei dieser Anordnung werden somit auf einem Kristall der integrierten Schaltung 50 Versorgungsnetze 51 angeordnet, wobei beispielhaft lediglich das VDD-Netz der Versorgungsspannung VDD als Gitterstruktur dargestellt ist. Eine Vielzahl der Anschlussstifte 52 ist Eingabe-Ausgabe-Funktionalitäten zugeordnet. Andere der Anschlussstifte 52 dienen zum Versorgen der integrierten Schaltung 50 mit Strom, wobei beispielhaft nur die VDD-Anschlussstifte dargestellt sind. Jedem der Anschlussstifte 52 ist genau ein Bonddraht als Schaltungsstrecke 3 zugeordnet. Diese Bonddrähte stellen durch die nicht monolithische Herstellungstechnik eine Hauptschwachstelle dar. Durch einen einfachen Kontakttest über die Anschlussstifte kann eine mangelhafte Verbindung jedes Bonddrahts und insbesondere der VDD-Bonddrähte sofort und einfach nachgewiesen werden, da jedem Bonddraht genau ein Anschlussstift 52 zugeordnet ist.

Fig. 5 zeigt eine neuere Ausführungsform einer Schaltungsanordnung des derzeit üblichen Standes der Technik, bei welcher die Versorgung mit Strom bzw. der Versorgungsspannung VDD nicht mehr über eine Vielzahl von Anschlussstiften 52 sondern über einen gemeinsamen einzelnen Anschlussstift 53 erfolgt. Der Anschlussstift 53 geht in eine parallel zu den Pads 1 verlaufende Schiene 54 über, wobei die an das entsprechende Versorgungsnetz 51 angeschlossenen Pads 1 jeweils über einen Bonddraht als einer Schaltungsstrecke 3 mit der Schiene 54 verbunden sind. Die Bonddrähte 3 sind durch die Schiene 54 auf der einen Seite und das Versorgungsnetz 51 der integrierten Schaltung 50 auf der anderen Seite praktisch kurzgeschlossen, so dass das Fehlen eines oder mehrerer solcher Bonddrähte unter Produktionsbedingungen nicht nachweisbar ist.

Eine vergleichbare Problematik zeigt sich auch bei anderen Anschlusstechniken von Versorgungsnetzen 51 einer solchen integrierten Schaltung 50, welche eine makroskopische, nicht-monolithische Parallelität aufweisen, wie beispielsweise Substrate, auf welche der Kristall aufgelötet oder aufgeklebt wird.

Zur Lösung der Problematik gibt es verschiedene Ansätze, welche jedoch alle zu keiner befriedigenden Lösung führen. Beispielsweise ist gemäß Fig. 6 aus US 5,521,511 eine Schaltungsanordnung bekannt, bei welcher über zwei Anschlussstifte 52a, 52b ein so hoher Strom eingeprägt werden soll, dass nennenswerte Spannungsfälle an Bonddrähten 3 entstehen, so dass fehlerhafte Verbindungen mit einem Spannungsmesser 67 detektiert werden können, welcher eine Spannung V zwischen den kontaktierten Pads 1a, 1b abgreift. Mittels einer Wannendiode 60 zwischen beispielsweise einer Versorgungsspannung VDD und einer Basisspannung VSS zwischen den Anschlussstiften 52a, 52b fällt vergleichsweise viel Spannung mit einer Prozessstreuung in Form eines parasitären Elements ab. Demgegenüber haben die Bonddrähte als Schaltungsstrecken 3 nur etwa 100 mOhm Widerstand, so dass die zu detektierenden Spannungsunterschiede durch fehlende Bonddrähte daher in der Variation anderer Spannungen untergehen. Nachteilhaft ist außerdem, dass für das Aufbringen sehr hoher Ströme im Amperebereich, welche für einen nennenswerten Abfall an 100 mOhm gebraucht werden, nachteilhafte Effekte für die Qualität des Produktes entstehen. Außerdem ist die Anzahl von parallelen Drähten oder anderen Verbindungselementen nicht auf zwei beschränkt, da auch zehn oder mehr verwendet werden können. Dies verschlechtert die Wahrscheinlichkeit der Detektion einer schlechten Verbindung zunehmend.

Aus DE 198 28 656 A1 ist eine integrierte Schaltung mit einer Kontaktierungsstelle zum Kontaktieren mit einem Bonddraht bekannt, welche eine Detektoreinrichtung zur Ermittlung des Zustands der Kontaktierungsstelle aufweist. Verwendet wird ein Verfahren zur Zustandserfassung an einem Pad selber, an welchem ein Potential abgegriffen wird. DE 689 12 982 T2 beschreibt ein Verfahren und eine Anordnung zum Testen mehrfacher Speiseverbindungen einer integrierten Schaltung auf einer Printplatte. Dabei wird ein Spannungsabfall an Leitungsbahnen zwischen parallelen Pads gemessen, wozu ein hoher Strom angelegt wird. DE 198 13 503 C1 beschreibt eine Schaltungsanordnung zum Verhindern von bei Kontaktfehlern auftretenden falschen Ergebnissen beim Testen einer integrierten Schaltung. Zwischen jeweiligen Pads und der integrierten Schaltung liegende Pull-up- oder Pull-down-Einrichtungen halten dabei jeweils durch Einprägen eines Haltestroms die Pads auf einem hohen oder niedrigen Potential, falls beim Testen das zugehörige Pin nicht kontaktiert ist, so dass eine Aktivierung des mit dem Pin verbundenen Schaltungsteils vermieden wird. US 5,801,536 beschreibt ein Prüfverfahren für integrierte Schaltungsanordnungen, wobei ein Stromfluss von einem Anschlussstift über Bonddrähte zu einem Pad, von dem Pad über einen Widerstand zu einem weiteren Pad und von dort über Bonddrähte zu einem weiteren Anschlussstift geleitet wird und dabei der Widerstandswert als Prüfkriterium gemessen wird.

D1 offenbart eine Anordnung zum prüfen einer Schaltungsstrecke, wobei ein wiederstand einer Verbindungsstercke als Meßshunt verwendet wird.

Die Aufgabe der Erfindung besteht darin, eine Prüfschaltungsanordnung bzw. ein Prüfverfahren zum Prüfen einer Schaltungsstrecke einer Schaltung vorzuschlagen, wobei ein Einprägen extrem hoher Ströme vermieden werden soll. Vorzugsweise sollen unter Produktionsbedingungen Spannungsunterschiede von einigen hundert oder einigen 100 µV aus Gesamtspannungen von insbesondere etwa 1V - 5V und deren erheblichen Schwankungen herausmessbar sein.

Diese Aufgabe wird gelöst durch eine Prüfschaltungsanordnung zum Prüfen einer Schaltungsstrecke einer Schaltung mit den

Merkmalen gemäß Patentanspruch 1 bzw. durch ein Prüfverfahren mit den Merkmalen gemäß Patentanspruch 13. Vorteilhafte Ausgestaltungen sind Gegenstand von abhängigen Ansprüchen

Bevorzugt wird eine Schaltungsanordnung zum Prüfen einer Schaltungsstrecke einer Schaltung mit einer an der Schaltungsstrecke anschließenden Verbindungsstrecke zum Leiten eines Stroms von oder zu der Schaltungsstrecke und mit einer Detektorschaltung, wobei ein erster Abgriff an der Verbindungsstrecke von einem Übergang zur Schaltungsstrecke beabstandet angeordnet ist, ein zweiter Abgriff an der Verbindungsstrecke näher an der Schaltungsstrecke als der erste Abgriff zur Schaltungsstrecke angeordnet ist und die Detektorschaltung eine Spannung oder eine spannungsäquivalente Größe zwischen dem ersten und dem zweiten Abgriff zum Prüfen der Schaltungsstrecke abgreift.

Dadurch können vorteilhaft beliebige Verbindungen getestet werden, wenn ein Strom hindurchfließt. Der Strom kann dabei ein künstlich angelegter oder ein sowieso fließender Strom sein. Vorteilhaft sind somit insbesondere auch Anordnungen, bei denen gar kein Messstrom eingeprägt werden muss, sondern bei denen der fließende Betriebsstrom ausreicht und für die Messung verwendet wird. Dadurch können Messungen im Hintergrund durchgeführt werden, während in geeigneter Weise andere Schaltungsteile getestet werden.

Bevorzugt wird insbesondere eine Prüfschaltungsanordnung, bei welcher die Detektorschaltung ausgebildet ist, einen elektrischen Widerstand der Verbindungsstrecke zwischen dem ersten und dem zweiten Abgriff zu erfassen.

Bevorzugt wird insbesondere eine Prüfschaltungsanordnung, bei welcher der elektrische Widerstand mindestens 10 mOhm entspricht. Bevorzugt wird insbesondere eine Prüfschaltungsanordnung, bei welcher die Detektorschaltung zum Detektieren einer Spannung kleiner 100 µV, insbesondere kleiner 1 mV zwischen dem ersten und dem zweiten Abgriff ausgebildet ist. Bevorzugt wird insbesondere eine Schaltung, bei welcher die zu überprüfende Schaltstrecke einen Bonddraht und die Verbindungsstrecke eine Anschlussmetallfläche aufweist.

Bevorzugt wird insbesondere eine Prüfschaltungsanordnung, bei welcher die Schaltungsstrecke zum Kontaktieren einer integrierten Schaltung ausgebildet ist. Bevorzugt wird insbesondere eine Prüfschaltungsanordnung, bei welcher die Schaltungsstrecke zum Anlegen einer Versorgungsspannung oder Basisspannung an ein Versorgungsnetz einer Schaltungsanordnung ausgebildet ist.

Bevorzugt wird insbesondere eine Prüfschaltungsanordnung, bei welcher zwei oder mehr Anordnungen aus in Reihe geschalteter Verbindungsstrecken und Schaltungsstrecken zueinander parallel geschaltet sind, wobei die Schaltungsstrecken auf deren den Verbindungsstrecken abgewandten Seiten mit einem gemeinsamen Anschlusspunkt verbunden sind und wobei die Verbindungsstrecken auf deren den Schaltungsstrecken abgewandten Seiten mit einem gemeinsamen Anschlusspunkt verbunden sind, so dass die zwei oder mehr zueinander parallel geschalteten Anordnungen aus Verbindungsstrecken und Schaltungsstrecken außenseitig kurzgeschlossen sind, und wobei beidseitig der Verbindungsstrecken jeweils ein erster und ein zweiter derartiger Abgriff angeordnet ist.

Bevorzugt wird insbesondere eine Prüfschaltungsanordnung, bei welcher jede der Verbindungsstrecken auf ihrer der jeweiligen Schaltungsstrecke abgewandten Seite mit einem Schalter, insbesondere Transistor, auf eine Basisspannung schaltbar ist. Transistoren sind jedoch nicht zwingend erforderlich sondern nur ein Beispiel dafür, wie ein Strom erzwungen werden kann, insbesondere mittels bereits vorhandener ESD-Transistoren (ESD: Electro Static Discharge / elektrostatische Entladung) erzwungen werden kann. Bevorzugter als der Einsatz von Transistoren ist beispielsweise die Ausnutzung eines Arbeitsstroms, der auch so durch die Leiter fließt.

Bevorzugt wird insbesondere eine Prüfschaltungsanordnung, bei welcher die Detektorschaltung zum Berücksichtigen von Widerständen auf der Seite der kurzgeschlossenen Schaltungsstrecken und auf der Seite der kurzgeschlossenen Verbindungsstrecken ausgebildet ist.

Bevorzugt wird insbesondere eine Prüfschaltungsanordnung mit zwei oder mehr zueinander parallel geschalteten Anordnungen aus jeweils einer Verbindungsstrecke und einer dazu in Reihe geschalteten Schaltungsstrecke und jeweils einem ersten und einem zweiten Abgriff an den Verbindungsstrecken und einer ersten und einer zweiten Leitung zum Abgreifen der Spannung bzw. spannungsäquivalenten Größe, wobei die Abgriffe jeweils mit einem Schalter auf die erste bzw. zweite Leitung schaltbar sind. Bevorzugt wird insbesondere eine Prüfschaltungsanordnung mit Transistoren als den Schalteinrichtungen.

Bevorzugt wird insbesondere eine Prüfschaltungsanordnung mit einem Zweidrahtbus zum Abgreifen der Spannung und Zuleiten zu einem Differenzverstärker.

Bevorzugt wird ein Verfahren zum Prüfen einer Schaltungsstrecke einer Schaltung, bei dem eine elektrische Spannung oder eine spannungsäquivalente Größe zum Überprüfen der Schaltungsstrecke gemessen wird, wobei die Spannung an einer direkt in Reihe zu der zu prüfenden Schaltungsstrecke geschalteten Verbindungsstrecke abgegriffen wird.

Bevorzugt wird insbesondere ein Verfahren, bei dem bei einer Vielzahl zueinander parallel geschalteter Anordnungen aus Schaltungsstrecken und Verbindungsstrecken mit jeweils zwei Abgriffen an jeder der Verbindungsstrecken die Abgriffe der verschiedenen Verbindungsstrecken auf zwei zu einer Detektoreinrichtung führenden Leiter gemultiplext werden.

Die Prüfschaltungsanordnung und das Prüfverfahren beruhen somit auf einem Messkonzept, bei welchem kein hoher Strom durch eine Gesamtstrecke mit möglicherweise schlecht definierten Parasiten geleitet werden muss und bei dem die Gesamtspannung nicht zwingend von außen gemessen werden muss. Vorteilhaft kann ein relativ kleiner Strom genutzt werden, um lokal in einer integrierten Schaltung auf einer Verbindung nach der anderen einen kleinen Spannungsabfall hervorzurufen, welcher symmetrisch nach außen geleitet wird oder sogar schon auf dem Chip der integrierten Schaltung selber ausgewertet werden kann. Dadurch liegen zwar relativ kleine Pegel vor, diese sind jedoch besser bekannt und stabiler, da ein Störeinfluss geringer und der Signalhub zwischen guten und offenen Verbindungen letztlich größer und damit eindeutiger ist.

Ausführungsbeispiele der Erfindung werden nachfolgend anhand der Zeichnung näher erläutert. Es zeigen:
- Fig. 1: schematisch einen Schaltungsausschnitt zur Veranschaulichung eines Grundprinzips einer Prüfschaltungsanordnung gemäß einem bevorzugten Ausführungsbeispiel,
- Fig. 2: eine beispielhafte Ausführungsform für eine Prüfschaltungsanordnung zum Prüfen einer Vielzahl paralleler Schaltungsstrecken,
- Fig. 3: eine weitere beispielhafte Prüfschaltungsanordnung zum Prüfen einer Vielzahl zueinander paralleler Schaltungsstrecken,
- Fig. 4: eine beispielhafte Schaltungsanordnung gemäß dem Stand der Technik,
- Fig. 5: eine weitere beispielhafte Schaltungsanordnung gemäß dem Stand der Technik und
- Fig. 6: eine noch weitere Schaltungsanordnung gemäß dem Stand der Technik.

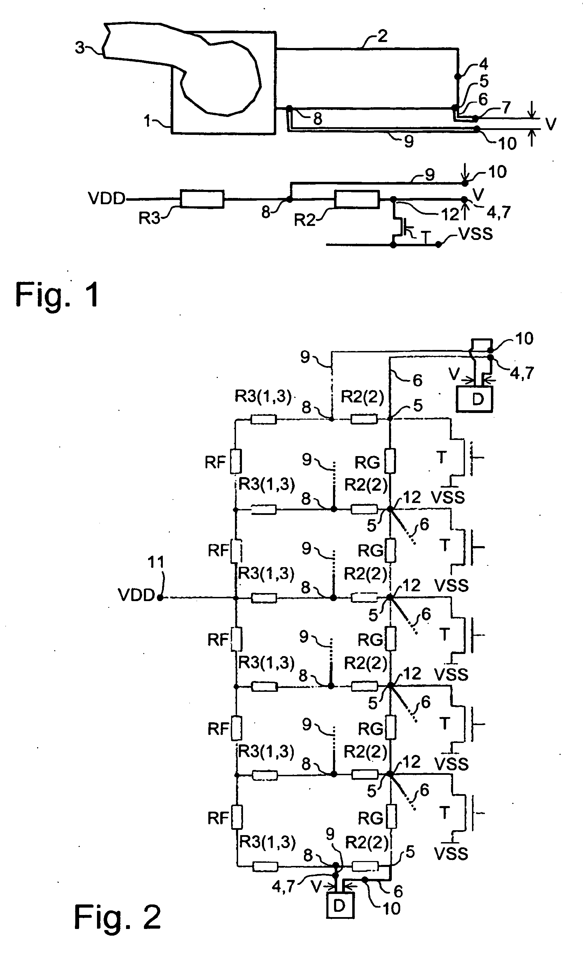

Wie dies schematisch aus Fig. 1 ersichtlich ist, besteht eine Prüfschaltungsanordnung zum Prüfen einer Schaltungsstrecke 1, 3 einer Schaltung gemäß einer einfachen Ausführungsform aus lediglich wenigen Komponenten. Die beispielhaft dargestellte Schaltungsstrecke 1, 3 besteht aus einem Pad 1, insbesondere Bondpad, welches zur Versorgung einer Verbindungsstrecke 2 aus einem metallischen, elektrisch leitfähigen Leiter ausgebildet ist. Die Verbindungsstrecke 2 dient zum Kontaktieren von Leiterbahnen und/oder Schaltungskomponenten der bezüglich weiterer Komponenten nicht dargestellten Schaltung. Besonders bevorzugt ist die Verbindungsstrecke 2 als ein integraler Bestandteil eines Versorgungsnetzes ausgebildet, wie es zur Versorgung einer integrierten Schaltung allgemein bekannt ist. Als besonders kritischer Bestandteil der zu überprüfenden Schaltungsstrecke 1, 3 ist beispielhaft ein Bonddraht 3 skizziert, welcher an dem Pad 1 angebondet ist. Prinzipiell können jedoch auch andere Arten von Schaltungsstrecken mit einer derartigen Prüfschaltungsanordnung überprüft werden.

Wesentlicher Bestandteil der Prüfschaltungsanordnung sind ein erster Abgriff 5 und ein zweiter Abgriff 8, welche an der Verbindungsstrecke 2 angeschlossen sind. Dabei ist der erste Abgriff 5 an der Verbindungsstrecke 2 von einem Übergang der Verbindungsstrecke 2 zur zu überprüfenden Schaltungsstrecke 1, 3 weiter beabstandet angeordnet als der zweite Abgriff 8. Wenn von der Schaltungsstrecke 1, 3 ein Stromfluss durch die Verbindungsstrecke 2 geleitet wird bzw. entsprechend ein Stromfluss in entgegengesetzter Richtung geleitet wird, entsteht auf Grund des geringen ohmschen Widerstandes des Materials der Verbindungsstrecke 2 eine geringe Potentialdifferenz zwischen dem ersten und dem zweiten Abgriff 5, 8, welche als eine Spannung V abgreifbar ist. Zum Abgreifen der Spannung dient eine erste Leitung 6, welche am ersten Abgriff 5 angeschlossen ist und an ihrem anderen Ende einen Kontaktpunkt 7 aufweist, sowie eine zweite Leitung 9, welche an dem zweiten Abgriff 8 angeschlossen ist und an ihrem anderen Ende einen weiteren Kontaktpunkt 10 aufweist. An den beiden Kontaktpunkten 7, 10 wird die Spannung V abgegriffen und mittels einer nicht dargestellten Detektoreinrichtung geprüft. Für den Fall, dass die Schaltungsstrecke 1, 3 unterbrochen ist, d. h. kein Strom durch die Verbindungsstrecke 2 fließt, ist der Wert der Spannung V gleich Null. Im Fall einer anliegenden Versorgungsspannung VDD und eines dadurch bedingt kontinuierlichen Stromflusses im Fall eines Anschlusskontakts zum Versorgen der integrierten Schaltung mit einer Betriebsspannung kann dadurch auf den Ausfall der Schaltungsstrecke geschlossen werden. Insbesondere bei mehreren parallel zueinander geschalteten und beidseitig kurzgeschlossenen derartigen Schaltungsstrecken ist dadurch auch der Ausfall einer einzelnen solcher Schaltungsstrecken 1, 3 sicher detektierbar.

Unterhalb der dargestellten Schaltungskomponenten ist in Fig. 1 ein entsprechendes elektrisches Ersatzschaltbild dargestellt. Die zu überprüfende Schaltungsstrecke 1, 3 ist durch einen Widerstand R3 repräsentiert und die daran angeschlossene Verbindungsstrecke 2 durch einen weiteren Widerstand R2 repräsentiert. Dargestellt ist außerdem der zweite Abgriff 8 zwischen den beiden Widerständen R3, R2, welcher über die zweite Leitung 9 zu dem Kontaktpunkt 10 führt. Jenseits des die Verbindungsstrecke 2 repräsentierenden Widerstands R2 führt ein entsprechender Leiter zu einem Kontaktpunkt 4, 7, wobei bei dem Ersatzschaltbild ein Anschlusspunkt 4 der Verbindungsstrecke 2 mit dem ersten Abgriff 5, der ersten Leitung 6 und dem ersten Kontaktpunkt 7 zusammengelegt ist. Prinzipiell könnte jedoch ein Anschlusspunkt 4 der zweiten Verbindungsstrecke 2 auch von dem ersten Abgriff 5 beabstandet liegen.

In dem Ersatzschaltbild ist außerdem ein Transistor T dargestellt, welcher zwischen dem ersten Kontaktpunkt 7 und eine Basisspannung VSS geschaltet ist. Zwischen der Versorgungsspannung VDD und der Basisspannung VSS sind somit in Reihe die beiden Widerstände R3, R2 und der optionale Transistor T geschaltet. Vorteilhafte Ausgestaltungen unter Verwendung eines solchen Transistors T zusätzlich zu der Auswertung der Spannung V werden anhand nachfolgender Ausführungsformen beschrieben.

Fig. 1 zeigt somit ein erstes besonders bevorzugtes Ausführungsbeispiel, bei dem ein Bonddraht 3 ein Bondpad kontaktiert. Das Pad 1 wird über eine monolithisch erzeugte Metallbahn mit einem Versorgungsnetz oder sonstigen Komponenten der Schaltung verbunden, welche zur Zeichnungsvereinfachung nicht dargestellt sind. Das elektrische Ersatzschaltbild zeigt zwei in Reihe geschaltete Widerstände R3, R2 für die zu überprüfende Schaltungsstrecke 1, 3 und die daran anschließende Verbindungsstrecke 2 in Form der Metallbahn.

Bei einer Vielzahl üblicher Ausgestaltungen integrierter Schaltungsanordnungen sitzen unter der Metallbahn der Verbindungsstrecke 2 ein Schutztransistor, insbesondere ESD-Schutztransistor (ESD: Electro Static Discharge / elektrostatische Entladung) oder andere aktive Elemente, welche in dem Ersatzschaltbild durch den Transistor T in Form eines beispielhaften MOS-Transistors (MOS: Metal Oxide Semiconductor/Metalloxidhalbleiter) symbolisiert ist.

Der Kern der Prüfschaltungsanordnung bzw. des Prüfverfahrens liegt in den Abgriffen 5, 8, welche insbesondere als dünne Messabgriffe und/oder dünne Leiter 6, 9 ausgebildet sind und einen Potentialunterschied in Form der Spannung V an der Verbindungsstrecke 2 abgreifen.

Gemäß einer üblichen und lediglich beispielhaften Ausführungsform kann mit einem elektrischen Widerstand von 40 mOhm für die Verbindungsstrecke 2 gerechnet werden, so dass bei einem Stromfluss von lediglich 10 mA durch die Schaltungsstrecke 1, 3 und die Verbindungsstrecke 2 mit einem Potentialunterschied von 400 µV gerechnet werden kann. Fehlt beispielsweise der Bonddraht 3 oder ist die Verbindung zum Pad 1 beschädigt, so ist der Potentialunterschied bzw. die gemessene Spannung V gleich 0. Bei realistischer Betrachtung ist der Wert nicht exakt gleich 0 sondern der Wert eines residualen Messrauschens geringfügig ungleich 0, was für die vorliegenden Betrachtungen auch als Null anzusehen ist. Schlimmer als ein solches und meist unerhebliches Messrauschen wirken sich Fehlspannungen aus, welche z.B. durch Leckströme auf einem Zweidrahtbus entstehen und mittels der Anordnung ebenfalls vorteilhaft erfasst werden können. Zur Überprüfung der Schaltungsstrecke steht somit ein zwar kleines aber dafür deutliches Signal für die Bestimmung der Güte jeder einzelnen derartigen Schaltungsstrecke, insbesondere Bondverbindung, zur Verfügung.

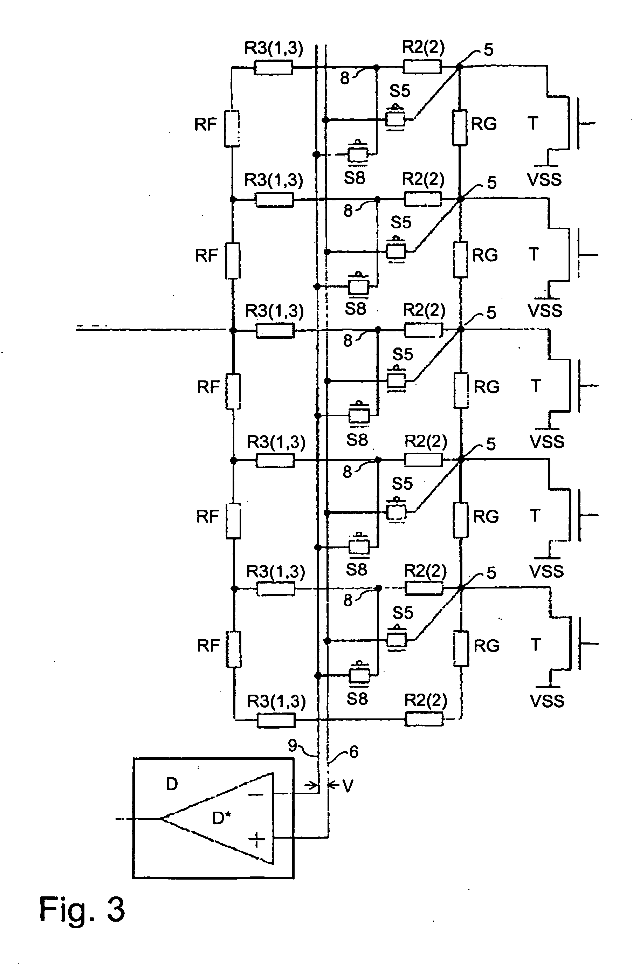

Das anhand Fig. 1 veranschaulichte Grundprinzip ist vorteilhaft auf auch komplexe Schaltungsanordnungen mit zueinander parallelen und beidseitig kurzgeschlossenen Verbindungen übertragbar, wie dies anhand der Fig. 2 und 3 veranschaulicht ist. Dabei werden im Wesentlichen nur Komponenten und Funktionalitäten näher beschrieben, welche anhand Fig. 1 nicht beschrieben wurden oder demgegenüber abweichen, während bezüglich weitere Komponenten und Funktionalitäten auf die Ausführungen zu Fig. 1 verwiesen wird. Zur Vereinfachung werden dabei Ersatzschaltbilder entsprechend dem Ersatzschaltbild gemäß Fig. 1 verwendet.

Fig. 2 zeigt eine Ausführungsform mit einem einzigen Anschlussstift 11 zum Anlegen einer Versorgungsspannung VDD. Die Versorgungsspannung VDD soll mit einer Vielzahl zueinander paralleler Schaltungsstrecken 1, 3 und diesen nachgeschalteten Verbindungsstrecken 2 zu einem gemeinsamen Anschlusspunkt 4 geleitet werden, wobei der Anschlusspunkt 4 zugleich als Kontaktpunkt 7 zum Abgreifen der Spannung V dient. Repräsentiert sind die Schaltungsstrecken 1, 3 und die Verbindungsstrecken 2 wieder durch entsprechende Widerstände R3 bzw. R2 im Ersatzschaltbild. Letztendlich bildet diese Anordnung der Schaltungsstrecken 1, 3 und der Verbindungsstrecken 2 insbesondere eine Sammelschiene, die irgendwo hingehen kann und die zur Prüfung Abgriffe 5, 8 hat. Zum Abgreifen der Spannung ist wiederum ein zweiter Abgriff 8 mit einer zweiten Leitung 9 vorgesehen, welche zu dem zweiten Kontaktpunkt 10 führt. An dem ersten und dem zweiten Kontaktpunkt 7, 10 wird entsprechend die Spannung V abgegriffen und einer lediglich beispielhaft dargestellten Detektorschaltung D zugeführt. Zwischen insbesondere jeder der Schaltungsstrecken 1, 3 und der Verbindungsstrecken 2 ist ein solcher zweiter Abgriff 8 vorgesehen. Aus Sicht dieser Schaltungsstrecken 1, 3 ist außerdem jenseits der zugeordneten Verbindungsstrecken 2 ein erster Abgriff 5 vorgesehen. Über entsprechende Leitungen 6, 9 und Kontaktpunkte 7, 10 ist jeweils eine Detektorschaltung angeschlossen, wobei dies abgesehen von der untersten Anordnung für die weiteren Anordnungen nur angedeutet ist.

Im Einzelnen ist eine derartige Schaltungsanordnung mit einer Vielzahl von Schaltungsstrecken 1, 3 und dazu jeweils in Reihe geschalteten Verbindungsstrecken 2 durch eine entsprechende Vielzahl von in Reihe geschalteter erster und zweiter Widerstände R3 bzw. R2 darstellbar. Die ersten Widerstände R3, welche die einzelnen Schaltungsstrecken 1, 3 repräsentieren, sind dabei über Reihenschaltungen aus Verteilerwiderständen RF an den Anschlusskontakt 11 mit der Versorgungsspannung VDD geschaltet. Auf der anderen Schaltungsseite, d. h. aus Sicht der ersten Widerstände R3 jenseits der zweiten Widerstände R2, sind die zweiten Widerstände R2 über Gitterwiderstände RG verbunden, welche einen Widerstand des entsprechenden Gittermaterials einer die Verbindungsstrecken 2 verbindenden Metallbahn repräsentieren. Dabei werden abgesehen von den beiden äußersten Verbindungsstrecken 2 jeweils eine Verbindungsstrecke 2 bzw. deren zweiter Widerstand R2 mit der Gitterbahn bzw. zwischen zwei Gitterwiderstände RG verbunden. Diese Verbindungen sind durch dritte Kontaktpunkte 12 im Ersatzschaltbild repräsentiert. An den dritten Kontaktpunkten 12 ist vorzugsweise wiederum jeweils ein Transistor T angeschlossen, welcher diese dritten Kontaktpunkte 12 im geschalteten Zustand mit der Basisspannung VSS verbindet. Die dritten Kontaktpunkte 12 dienen bei der dargestellten Variante zugleich als erste Abgriffe 5.

Bei dieser Ausführungsform ist somit die Versorgungsspannung VDD über einen verteilten Verteilerwiderstand RS, durch erste Widerstände R3 repräsentierte zueinander parallele Bonddrähte 3 sowie jeweils in Serie dazu geschaltete Verbindungsstrecken 2 als Metallbahnen in Form skizzierter zweiter Widerstände R2 geschaltet. Dass die Verbindungsstrecken 2 bzw. zweiten Widerstände R2 zusammenschaltende Versorgungsgitter wird durch die Gitterwiderstände RG modelliert. Am Beispiel der in Fig. 2 obersten und untersten Verbindungsstrecke bzw. des obersten und untersten zweiten Widerstands R2 sind wiederum zwei Drähte bzw. Leiter 6, 9 an entsprechenden Abgriffen 5, 8 angeordnet, um die Spannung V über diese Verbindungsstrecke 2 bzw. den dieser entsprechenden zweiten Widerstand R2 abzuleiten. Zur Detektion muss ein Strom durch den entsprechenden zweiten Widerstand R2 bzw. durch die Verbindungsstrecke 2 fließen. Dies kann auch ein Leckstrom eines in der Zeichnung nicht dargestellten Versorgungsnetzes, welches die Versorgungsspannung VDD bereitstellt, oder ein Strom, insbesondere MOS-Strom durch je einen der Transistoren T pro Verbindungsstrecke 2 bzw. pro zweitem Widerstand R2 sein. Dazu kann vorteilhafter Weise ein solcher Transistor T in Form eines üblicherweise vorhandenen ESD-Transistors eingesetzt werden, dessen Stromquellencharakteristik vorteilhaft ausnutzbar ist.

Eine Detektion eines Ausfalls einer der Schaltungsstrecken 1, 3 bzw. im Ersatzschaltbild eines der ersten Widerstände R3 ist somit durch Abgreifen der Spannung V an den zugeordneten Abgriffen 5, 8 auf Grund einer Änderung des zu erwartenden Spannungswertes zu einem dazu abweichenden Spannungswert erkennbar. Vorteilhaft können durch entsprechende Schaltungen der Transistoren T verschiedene der dritten Kontaktpunkte 12 so angesteuert werden, dass ermittelbar ist, welche der einzelnen Schaltungsstrecken 1, 3 defekt ist.

Fig. 3 zeigt eine gegenüber Fig. 2 modifizierte Ausführungsform. Anstelle eines einzigen Messabgriffs über nur eine der Verbindungsstrecken 2 bzw. über nur einen der zweiten Widerstände R2 ist jeder der in Reihe geschalteten Gruppen aus jeweils einer zu überwachenden Schaltungsstrecke 1, 3 und einer Verbindungsstrecke 2 bzw. im Ersatzschaltbild entsprechend jeder in Reihe geschalteter Gruppe aus einem ersten und einem zweiten Widerstand R3, R2 eine eigene Gruppe aus zwei Abgriffen 5, 8 zugeordnet. Dabei sind die jeweils zwei Abgriffe 5, 8 über jeweils einen diesen zugeordneten Schalter S5, S8, an einen ersten bzw. einen zweiten Leiter 6 bzw. 9 geschaltet. Die Schalter S5, S8 einer jeden Gruppe werden dabei so geschaltet, dass jeweils nur der erste und der zweite Abgriff 5, 8 einer einzigen Verbindungsstrecke 2 bzw. des dieser im Ersatzschaltbild zugeordneten Widerstands R2 aus der Vielzahl paralleler Verbindungsstrecken 2 auf die erste bzw. zweite Leitung 6, 9 geschaltet wird. Die beiden Leitungen 6, 9 werden bei der dargestellten Ausführungsform einem Differenzverstärker D* als Bestandteil der Detektorschaltung angelegt.

Bei einer solchen Ausführungsform können insbesondere Vorteile der MOS-Technik ausgenutzt werden, indem für alle interessanten Bonddrähte oder sonstige nicht-monolithische Verbindungen die Differenzspannung an den jeweiligen Verbindungsstrecken 2 bzw. zweiten Widerständen R2 abgenommen und mit MOS-Schaltern als den Schaltern S5, S8 auf einen Zweidrahtbus in Form der ersten und zweiten Leitung 6, 9 multiplext und so dem Differenzverstärker D* zugeführt wird. Der Differenzverstärker D* kann dabei innerhalb oder außerhalb der integrierten Schaltung liegen. Sequenziell können so die jeweiligen MOS-Transistoren der Schalter S5, S8 aktiviert, die Differenzspannungen auf den Bus gelegt und das Ergebnis am Ausgang des Differenzverstärkers D* ausgelesen werden.

Auf diese Art und Weise kann eine große Anzahl von Bond-, Löt- oder sonstigen anfälligen Verbindungen während der Produktion einer integrierten Schaltung automatisch getestet werden. Neben einer Überprüfung während der Produktion einer integrierten Schaltung kann eine derartige Schaltung auch später im Betrieb in beispielsweise regelmäßigen Abständen getestet werden, um beispielsweise Ermüdungsbrüche oder auf Grund sonstiger Einflüsse aufgetretene Defekte der Schaltungsstrecken zu erkennen.

Die MOS-Schalter S5, S8 und die zu deren Verschaltung verwendeten dünnen Drähte weisen vorzugsweise beachtliche Widerstände auf, welche im kOhm-Bereich liegen. Entsprechend wird der Differenzverstärker D* derart hochohmig gewählt, dass praktisch kein Strom durch diese effektiven Widerstandselemente fließt. Im Rahmen eines Prüfverfahrens unter Verwendung einer solchen Prüfschaltungsanordnung wird vorzugsweise pro Messung eine ausreichende Zeitdauer vorgesehen, welche eine gewisse Einschwingzeit berücksichtigt, wie sie für jede präzise analoge Messung üblicherweise benötigt wird. Der Offset des Differenzverstärkers D* wird vorzugsweise durch für sich bekannte Schaltungstechniken klein gehalten, beispielsweise durch offsetarme bipolare Eingangsstufen oder durch selbst kompensierende Techniken mit Abgleichschritt.

Fehlströme, insbesondere Leckströme, auf den Leitungen 6, 9 können auch Offsets erzeugen. Zur besseren Auswertung kann daher eine Messstelle in Form eines Widerstands R2 oder einer Strecke zwischen zwei Abgriffen 5, 8 eingebaut werden, durch die kein Nutzstrom fließen kann, wodurch also das Fehlen der Strecke bzw. des Widerstands R3, insbesondere Leitungswiderstands, simuliert werden kann. Dadurch hat man einen Vergleichswert, mit dem Offsetfehler ebenfalls kompensiert werden können. Gegebenenfalls können damit auch Signale, die mit z.B. 10 µV eine Größenordnung kleiner sind, noch eindeutig zugeordnet werden.

Eine Umsetzung derartiger Schaltungsanordnungen ist prinzipiell in jeder Schaltungstechnik möglich, in welcher eine Prüfung der Zuverlässigkeit von Verbindungen vorgenommen werden soll. Dabei können Module aus diskreten Komponenten, aus Multichip-Modulen oder eine einzige integrierte Schaltung in einem Gehäuse sowie Mischformen daraus eingesetzte werden. Besonders vorteilhaft ist die Umsetzung einer solchen Prüfschaltungsanordnung bei der Fertigung von integrierten Schaltungen mit vielen parallelen Versorgungspfaden, welche mit solchen Prüfschaltungsanordnungen auf einfachere Art und Weise sicher geprüft werden können.

Auch die Verwendung von MOS-Transistoren bzw. CMOS-Technik sowie von NMOS- oder PMOS-Techniken ist möglich. Für die Beaufschlagung der Busse bzw. Leiter können auch Bipolartransistoren als Schalter verwendet werden und zum Einleiten von Strömen eingesetzt werden.

Anhand der dargestellten Ausführungsbeispiele wurde lediglich ein Versorgungsnetzwerk zum Anlegen einer Versorgungsspannung VDD dargestellt. Insbesondere durch die Verwendung von z. B. PMOST als Stromquellen können auch Verbindungen zu einem VSS-Netzwerk, welches auf einer Basisspannung VSS liegt, gemessen werden. Auch mehrer zueinander verschiedene Netze können überprüft werden, da durch die Einschaltung von Serienwiderständen auf dem Zweidrahtbus bzw. dem ersten und dem zweiten Leiter auch ESD-Probleme zwischen den verschiedenen Netzen vermieden werden können.

Neben der Überprüfung von Bonddrähten und deren Schweißstellen als Schaltungsstrecke sind auch andersartige Schaltungsstrecken bzw. Verbindungen überprüfbar. Prinzipiell ist eine Prüfung an jeglicher Verbindungstechnik möglich, sei es durch Kleben, Löten, Schweißen, Bonddrähte, Substrate, Flip-Chip, so lange die Übertragung von Signalen nicht gänzlich drahtlos durch Wellen erfolgt.

In erster Linie dient eine solche Prüfschaltungsanordnung zum Überprüfen paralleler Versorgungspfade. Eingabe-Ausgabe.

Anschlüsse sind ihrer Natur nach in diesem Sinne üblicherweise nicht parallel geschaltet und können daher in für sich bekannter Art und Weise konventionell gemessen werden. Trotzdem besteht prinzipiell auch die Möglichkeit, die vorliegende Prüfschaltungsanordnung mit einer besseren Bewertungsmöglichkeit auch auf solchen Signalpfaden einzusetzen, auf welchen keine Parallelisierung angewendet wird. Dies ermöglicht insbesondere eine einheitliche Überprüfung sämtlicher Anschlusskontakte bzw. Anschlussstifte an beispielsweise einem Gehäuse einer integrierten Schaltung, da mittels eines einzigen Prüfverfahrens bzw. eines einzigen Typs von einer Prüfschaltungsanordnung sämtliche Schaltungsstrecken überprüfbar sind. Somit können auch Ein-Ausgabe-Schaltungsstrecken als zusätzliche zu überprüfende Strecken in insbesondere ein System mit auf die beiden Leitungen geschalteten Verbindungsstrecken eingereiht werden.

## Patentansprüche

1. Prüfschaltungsanordnung zum Prüfen einer Schaltungsstrecke (1, 3) einer Schaltung, mit
- einer Detektorschaltung (D),
wobei die Schaltungsstrecke aus einem Bonddraht (3) und einem als Bondpad ausgebildeten Pad (1) besteht mit
- einer an der Schaltungsstrecke (1, 3) anschließenden Verbindungsstrecke (2) zum Leiten eines Stroms von oder zu der Schaltungsstrecke (1, 3) und
die Verbindungsstrecke (2) als Metallbahn ausgeführt und in Serie mit dem Bonddraht (3) und dem Bondpad geschaltet ist, und
ein erster Abgriff (5 - 7) an der Verbindungsstrecke (2) von einem Obergang zur Schaltungsstrecke (1, 3) beabstandet angeordnet ist,
- ein zweiter Abgriff (8 - 10) an der Verbindungsstrecke (2) näher an der Schaltungsstrecke (1, 3) als der erste Abgriff zur Schaltungsstrecke (1, 3) angeordnet ist und
die Detektorschaltung (D) so konfiguriert ist, dass sie eine Spannung (V) oder eine spannungsäquivalente Größe zwischen dem ersten und dem zweiten Abgriff (5 - 7, 8 - 10) zum Prüfen der Schaltungsstrecke (3) abgreift, **gekennzeichnet dadurch dass**

2. Prüfschaltungsanordnung nach Anspruch 1, bei welcher jede der Verbindungsstrecken (2) auf ihrer der jeweiligen Schaltungsstrecke (1, 3) abgewandten Seite mit einem Schalter, insbesondere Transistor (T), auf eine Basisspannung (VSS) schaltbar ist.

3. Prüfschaltungsanordnung nach Anspruch 1 oder 2, bei welcher die Detektorschaltung (D) zum Berücksichtigen von Widerstanden (RG, RS) auf der Seite der kurzgeschlossenen Schaltungsstrecken (1, 3) und auf der Seite der kurzgeschlossenen Verbindungsstrecken (2) ausgebildet ist.

4. Prüfschaltungsanordnung nach einem vorstehenden Anspruch mit zwei oder mehr zueinander parallel geschalteten Anordnungen aus einer Verbindungsstrecke (2) und einer dazu in Reihe geschalteten Schaltungsstrecke (1, 3), mit jeweils einem ersten und einem zweiten Abgriff (5, 8) an den Verbindungsstrecken (2) und mit einer ersten und einer zweiten Leitung (6, 9) zum Abgreifen der Spannung (V), wobei die Abgriffe (5, 8) jeweils mit einem Schalter (S5, S8) auf die erste bzw. zweite Leitung (6, 9) schaltbar sind.

5. Prüfschaltungsanordnung nach Anspruch 4 mit Transistoren als den Schalteinrichtungen (S5, S8).

6. Prüfschaltungsanordnung nach einem vorstehenden Anspruch mit einem Zweidrahtbus zum Abgreifen der Spannung (V) und zum Zuleiten zu einem Differenzverstärker (D*).

7. Prüfschaltungsanordnung nach Anspruch 1, bei welcher die Detektorschaltung (D) ausgebildet ist, einen elektrischen Widerstand der Verbindungsstrecke (2) zwischen dem ersten und dem zweiten Abgriff (5 - 7, 8 - 10) zu erfassen.

8. Prüfschaltungsanordnung nach Anspruch 7, bei welcher der elektrische Widerstand mindestens 10 m0hm entspricht.

9. Prüfschaltungsanordnung nach einem vorstehenden Anspruch, bei welcher die Detektorschaltung (D) zum Detektieren einer Spannung kleiner 100 µV, insbesondere kleiner 1 mV zwischen dem ersten und dem zweiten Abgriff (5, 8) ausgebildet ist.

10. Prüfschaltungsanordnung nach einem vorstehenden Anspruch, bei welcher die zu überprüfende Schaltungsstrecke (1, 3) einen Bonddraht (3) und die Verbindungsstrecke (2) eine Anschlussmetallflache aufweist.

11. Prüfschaltungsanordnung nach einem vorstehenden Anspruch, bei welcher die Schaltungsstrecke (1, 3) zum Kontaktieren einer integrierten Schaltung ausgebildet ist.

12. Prüfschaltungsanordnung nach einem vorstehenden Anspruch, bei welcher die Schaltungsstrecke (1, 3) zum Anlegen einer Versorgungsspannung (VDD) oder Basisspannung (VSS) an ein Versorgungsnetz einer Schaltungsanordnung ausgebildet ist.

13. Verfahren zum Prüfen einer Schaltungsstrecke (1, 3) bestehend aus einem Bonddraht (3) und einem Bondpad (1) einer Schaltung und einer Verbindungsstrecke während des Betriebs der Schaltung, bei dem eine elektrische Spannung oder eine spannungsäquivalente Größe zum Oberprüfen der Schaltungsstrecke gemessen wird, wobei
die Verbindungsstrecke (2) als Metallbahn ausgeführt und in Serie mit dem Bonddraht (3) und dem Bondpad geschaltet ist, und
die Spannung (V) an einer direkt in Reihe zu der zu prüfenden Schaltungsstrecke geschalteten Verbindungsstrecke (2) abgegriffen wird, **dadurch gekennzeichnet, dass**
zwei oder mehr Anordnungen aus in Reihe geschalteter Verbindungsstrecken und Schaltungsstrecken zueinander parallel geschaltet sind, wobei die Schaltungsstrecken (1, 3) auf deren den Verbindungsstrecken (2) abgewandten Seiten mit einem gemeinsamen Anschlusspunkt (11) verbunden sind und wobei die Verbindungsstrecken (2) auf deren den Schaltungsstrecken abgewandten Seiten mit einem gemeinsamen Anschlusspunkt (4) verbunden sind, so dass die zwei oder mehr zueinander parallel geschalteten Anordnungen aus Verbindungsstrecken (2) und Schaltungsstrecken (1, 2) außenseitig kurzgeschlossen sind, und wobei beidseitig der Verbindungsstrecken (2) jeweils ein derartiger erster und ein derartiger zweiter Abgriff (5 - 7, 8 - 10) angeordnet ist.

14. Verfahren nach Anspruch 13, bei dem bei einer Vielzahl zueinander parallel geschalteter Anordnungen aus Schaltungsstrecken (1, 3) und Verbindungsstrecken (2) mit jeweils zwei Abgriffen an jeder der Verbindungsstrecken (2) die Abgriffe (5, 8) der verschiedenen Verbindungsstrecken (2) auf zwei Leiter (6, 9) gemultiplext werden.

## Claims

1. Test circuit arrangement for testing a circuit path (1, 3) of a circuit, comprising
- a detector circuit (D), wherein the circuit path consists of a bond wire (3) and a pad (1) constructed as a bond pad, with
- a connecting path (2), which is connected with the circuit path (1, 3), for conducting a current from or to the circuit path (1, 3) and
the connecting path (2) is constructed as a metal path and connected in series with the bond wire (3) and the bond pad, and a first tap (5 - 7) is arranged at the connecting path (2) at a spacing from a transition to the circuit path (1, 3),
- a second tap (8 - 10) is arranged at the connecting path (2) closer to the circuit path (1, 3) than the first tap to the circuit path (1, 3) and
the detector circuit (D) is so configured that it taps a voltage (V) or a voltage-equivalent magnitude between the first and the second taps (5 - 7, 8 - 10) for testing the circuit path (3), **characterised in that**
two or more arrangements of connecting paths and circuit paths connected in series are connected in parallel with one another, wherein the circuit paths (1, 3) on the sides thereof remote from the connecting paths (2) are connected with a common connecting point (11) and wherein the connecting paths (2) on the sides thereof remote from the circuit paths are connected with a common connecting point (4) so that the two or more arrangements, which are connected in parallel, of connecting paths (2) and circuit paths (1, 2) are short-circuited at the outer side, and wherein a respective first and second tap (5 - 7, 8 - 10) of that kind is arranged on each side of the connecting paths (2).

2. Test circuit arrangement according to claim 1, in which each of the connecting paths (2) on its side remote from the respective circuit path (1, 3) is switchable by a switch, particularly a transistor (T), to a base voltage (VSS).

3. Test circuit arrangement according to claim 1 or 2, in which the detector circuit (D) is constructed for consideration of resistances (RG, RS) on the side of the short-circuited circuit paths (1, 3) and on the side of the short-circuited connecting paths (2).

4. Test circuit arrangement according to any one of the preceding claims with two or more arrangements, which are connected in parallel with one another, of a connecting path (2) and a circuit path (1, 3) connected in series therewith, with a respective first and second tap (5, 8) at the connecting paths (2) and with a first and second line (6, 9) for tapping the voltage (V), wherein the taps (5, 8) are respectively switchable by a switch (S5, S8) to the first or second line (6, 9).

5. Test circuit arrangement according to claim 4 with transistors as the switching devices (S5, S8).

6. Test circuit arrangement according to any one of the preceding claims, with a two-wire bus for tapping the voltage (V) and for feeding it to a differential amplifier (D*).

7. Test circuit arrangement according to claim 1, in which the test circuit (D) is constructed to detect an electrical resistance of the connecting path (2) between the first and the second tap (5 - 7, 8 - 10).

8. Test circuit arrangement according to claim 7, in which the electrical resistance corresponds with at least 10 mOhm.

9. Test circuit arrangement according to any one of the preceding claims, in which the detector circuit (D) is constructed for detecting a voltage of less than 100 µV, particularly less than 1 mV between the first and the second tap (5, 8).

10. Test circuit arrangement according to any one of the preceding claims, in which the circuit path (1, 3) to be tested comprises a bond wire (3) and the connecting path (2) comprises a connecting metal surface.

11. Test circuit arrangement according to any one of the preceding claims, in which the circuit path (1, 3) is constructed for contacting an integrated circuit.

12. Test circuit arrangement according to any one of the preceding claims, in which the circuit path (1, 3) is constructed for application of a supply voltage (VDD) or base voltage (VSS) to a power supply mains of a circuit arrangement.

13. Method for checking a circuit path (1, 3) consisting of a bond wire (3) and a bond pad (1) of a circuit and a connecting path during operation of the circuit, in which an electrical voltage or a voltage equivalent magnitude is measured for testing the circuit path, wherein the connecting path (2) is formed as a metal path and connected in series with the bond wire (3) and the bond pad, and the voltage (V) is tapped at a connecting path (2) connected directly in series with the circuit path to be tested, **characterised in that** two or more arrangements of connecting paths and circuit paths connected in series are connected in parallel with one another, wherein the circuit paths (1, 3) on the sides thereof remote from the connecting paths (2) are connected with a common connecting point (11) and wherein the connecting paths (2) on the sides thereof remote from the circuit paths are connected with a common connecting point (4) so that the two or more arrangements, which are connected in parallel, of connecting paths (2) and circuit paths (1, 2) are short-circuited at the outer side, and wherein a respective first and second tap (5 - 7, 8 - 10) of that kind is arranged on each side of the connecting paths (2).

14. Method according to claim 13, in which in the case of a plurality of arrangements, which are connected in parallel with one another, of circuit paths (1, 3) and connecting paths (2) each with two taps at each of the connecting paths (2) the taps (5, 8) of the different connecting paths (2) are multiplexed on two lines (6, 9).

## Revendications

1. Circuit de vérification pour la vérification d'une zone de circuit (1,3) d'un circuit comprenant :
. un circuit de détection (D) dans lequel la zone de circuit se compose d'un fil de liaison (3) et d'un tapis (1) conformé en tapis de liaison,
. une zone de liaison (2) contigue à la zone de circuit (1,3) pour conduire un courant venant de, ou allant à, la zone de circuit (1,3) et, la zone de liaison (2) étant réalisée sous la forme d'une bande métallique et étant montée en série dans le circuit avec la liaison filaire (3) et le tapis de liaison et un premier branchement (5-7) prévu à la zone de liaison (2) à l'écart d'une passerelle vers la zone de circuit (1,3),
. un deuxième branchement (8-10) prévu à la zone de liaison (2) plus proche de la zone de circuit ((1,3) que le premier branchement vers la zone de circuit (1,3) et,
le circuit de détection (D) étant configuré de façon que la tension (V) ou une grandeur équivalente de tension entre le premier et le deuxième branchements (5-7, 8-10) soit prise pour la vérification de la zone de circuit (3)
**caractérisé en ce que**
sur les ensembles montés en série dans la zone de liaison et la zone de circuit (3), deux ou plus sont montés en parallèle, ensemble dans lequel les zones de circuit (1,3) sur lesquelles les faces opposées des zones de liaison (2) sont reliées par un point de connexion commun (11) et **en ce que** les zones de liaison (2) sur les faces opposées desquelles les zones de circuit sont reliées par un point de connexion commun (4) de telle façon que les deux ou plus ensembles montés en parallèle l'un derrière l'autre dans le circuit provenant des zones de liaison (2) et des zones de circuit (1,3) soient en circuit court sur leur face latérale extérieure et qu'il soit prévu sur les deux faces de la zone de liaison (2) à chaque fois un premier et un deuxième branchements de ce type (5-7, 8-10).

2. Circuit de vérification selon la revendication 1 **caractérisé en ce que** chacune des zones de liaison (2) est commutable par un commutateur en particulier un transistor (T), à l'aide d'une tension appliquée sur sa base (VSS), commutateur monté sur chacune des faces opposées de leurs zones de liaison (1,3).

3. Circuit de vérification selon la revendication 1 ou 2 **caractérisé en ce que** le circuit de détection tenant compte des résistances (RG, RS) se trouve sur la face des zones de circuits courts (1,3) et sur la face des zones de liaison courtes (2).

4. Circuit de vérification selon l'une des revendications précédentes **caractérisé par** deux ou plus d'ensembles montés en circuit parallèle d'une zone de liaison (2) et en plus une zone de circuit (1, 3) montée en série avec à chaque fois un premier et un deuxième branchements (5,8) à la zone de liaison (2) et avec une première et une deuxième liaison conductrice (6,9) pour prélever la tension (V), dans lequel chacun des branchements (5,8) est commutable par un commutateur (S5, S8) respectivement sur la première et la deuxième liaison conductrice (6, 9).

5. Circuit de vérification selon la revendication 4 **caractérisé en ce que** les dispositifs de commutation (S5, S8) sont des transistors.

6. Circuit de vérification selon l'une des revendications précédentes **caractérisé par** un bus à deux lignes pour le prélèvement de la tension (V) et l'envoi à un amplificateur différentiel (D*).

7. Circuit de vérification selon la revendication 1 **caractérisé en ce que** le circuit de détection (D) est réalisé pour détecter une résistance électrique de la zone de liaison (2) entre le premier et le deuxième branchements (5-7, 8-10).

8. Circuit de vérification selon la revendication 7 **caractérisé en ce que** la valeur de la résistance est d'au moins 10 mOhm.

9. Circuit de vérification selon l'une des revendications précédentes **caractérisé par** un circuit de détection (D) prévu pour la détection d'une tension inférieure à 100 µV, en particulier inférieure à 1 mV, entre le premier et le deuxième branchement (5, 8).

10. Circuit de vérification selon l'une des revendications précédentes **caractérisé par** une liaison filaire (3) pour vérifier la zone de circuit (1,3) et par une connexion métallique plate pour la zone de liaison (2).

11. Circuit de vérification selon l'une des revendications précédentes **caractérisé en ce que** la zone de circuit (1,3) est conformée pour entrer en contact avec un commutateur intégré.

12. Circuit de vérification selon l'une des revendications précédentes **caractérisé en ce que** la zone de circuit (1,3) est prévue pour appliquer une tension d'alimentation (VDD) ou une tension de base (VSS) au réseau d'alimentation d'un ensemble commutateur.

13. Procédé pour la vérification d'une zone de circuit (1,3) composée d'une liaison filaire (3) et d'un circuit de tapis de liaison (1) et une zone de liaison pendant le fonctionnement du circuit, selon lequel on mesure une tension électrique ou une grandeur équivalente à une tension pour la vérification de la zone de circuit, selon lequel la zone de liaison (2) est réalisée sous la forme d'une bande de métal et est montée en série dans le circuit avec la liaison filaire (3) et le tapis de liaison et la tension (V) étant prélevée sur une zone de liaison (2) montée dans le circuit directement en série avec la zone de circuit à vérifier,
**caractérisé en ce que**
sur les ensembles montés en série dans la zone de liaison et la zone de circuit (3), deux ou plus sont montés en parallèle, ensemble dans lequel les zones de circuit (1,3) sur lesquelles les faces opposées des zones de liaison (2) sont reliées par un point de connexion commun (11) et **en ce que** les zones de liaison (2) sur les faces opposées desquelles les zones de circuit sont reliées par un point de connexion commun (4) de telle façon que les deux ou plus ensembles montés en parallèle l'un derrière l'autre dans le circuit provenant des zones de liaison (2) et des zones de circuit (1,3) soient en circuit court sur leur face latérale extérieure et qu'il soit prévu sur les deux faces de la zone de liaison (2) à chaque fois un premier et un deuxième branchements de ce type (5-7, 8-10).

14. Procédé selon la revendication 13 **caractérisé en ce que**, dans le cas d'une pluralité d'ensembles de zones de circuit (1,3) et de zones de liaison (2) montés en parallèle les unes derrière les autres avec à chaque fois deux branchements à chaque zone de liaison (2), les branchements (5, 8) des différentes zones de liaison (2) sont multiplexés sur deux lignes (6, 9).
